Europäisches Patentamt

European Patent Office

Office européen des brevets

(11) Numéro de publication: **0 369 895**
**A1**

## (12) DEMANDE DE BREVET EUROPEEN

(21) Numéro de dépôt: 89420390.0

(22) Date de dépôt: **13.10.89**

(51) Int. Cl.5: **H01L 29/788, H01L 27/10, H01L 21/82, G11C 17/00**

(30) Priorité: **17.10.88 FR 8814598**

(43) Date de publication de la demande:
**23.05.90 Bulletin 90/21**

(84) Etats contractants désignés:
**DE FR GB IT NL**

(71) Demandeur: **SGS-THOMSON MICROELECTRONICS S.A.**
**7, Avenue Galliéni**
**F-94250 Gentilly(FR)**

(72) Inventeur: **Guillaumot, Bernard**
**14, Rue du Rocher**
**F-38120 Le Fontanil(FR)**

(74) Mandataire: **de Beaumont, Michel**
**1bis, rue Champollion**
**F-38000 Grenoble(FR)**

(54) **Mémoire EPROM de type damier et procédé de fabrication.**

(57) La présente invention concerne une mémoire dont les points-mémoire sont constitués de transistors à grille flottante, chaque transistor comprenant deux régions constituées de diffusions du premier type de conductivité qui se prolongent suivant des colonnes pour former des lignes de bit (LB) dans un substrat semiconducteur (11) du deuxième type de conductivité, une couche d'isolement (13) recouvrant chaque ligne de bit (LB), des lignes de mot (LM) conductrices s'étendant selon des rangées pour recouvrir chacune des grilles flottantes (19) des transistors de cette rangée. La grille flottante (19) de chaque transistor est constituée d'une portion d'une unique couche conductrice qui s'étend entre chaque paire de couches d'isolement (13) et les recouvre partiellement, ladite portion étant revêtue d'un isolant sur toutes ses surfaces.

Figure 2E

# MEMOIRE EPROM DE TYPE DAMIER ET PROCEDE DE FABRICATION

La présente invention concerne les mémoires à semiconducteur, et plus particulièrement les mémoires non-volatiles électriquement programmables, ou mémoires EPROM, à grille flottante.

Pour obtenir des mémoires de grande capacité de stockage, par exemple des mémoires capables de stocker jusqu'à 16 mégabits, on doit réduire le plus possible la dimension de chacun des points-mémoire constituant la mémoire.

La demande de brevet français 86/12938 déposée le 16 septembre 1986 présente des structures dites en damier, qui éliminent des parties qui occupent une place importante et qui sont constituées par des zones d'oxyde épais et des contacts multiples vers les drains ou sources des transistors.

Une telle structure en damier est composée d'un réseau de lignes de mot s'étendant suivant des rangées reliant les grilles de commande des transistors, et de lignes de bit s'étendant suivant des colonnes, reliant les drains ou bien les sources des transistors.

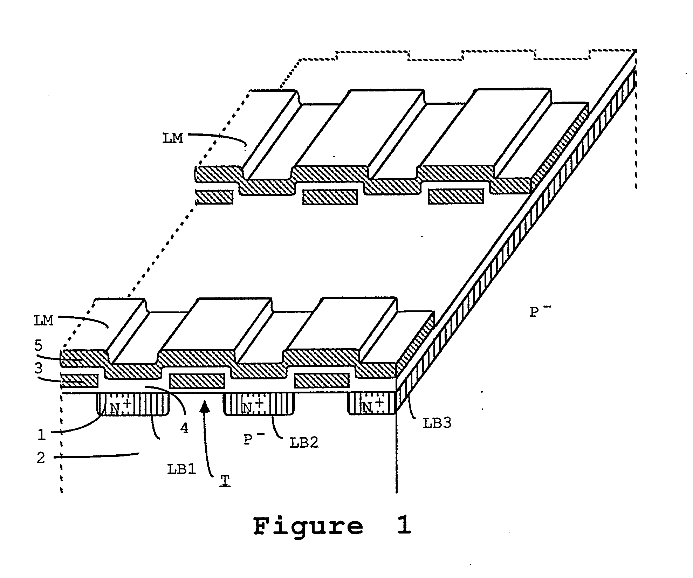

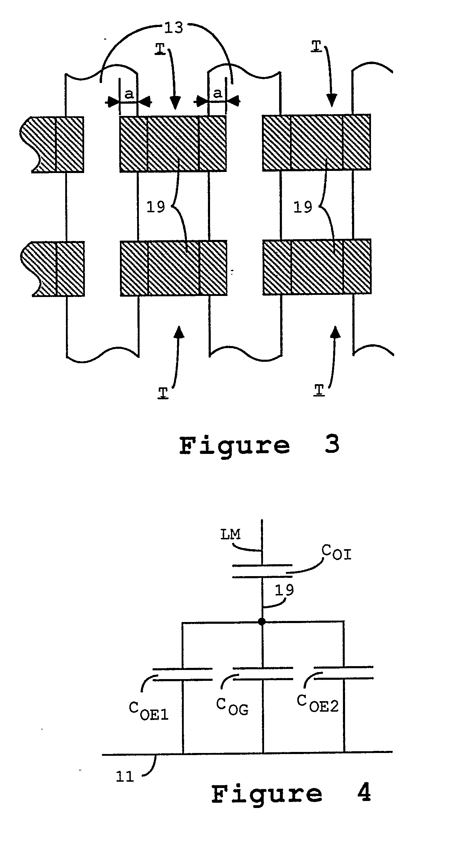

La figure 1 représente une vue partielle en coupe et en perspective de points-mémoire adjacents d'une structure en damier correspondant à la figure 4 du document susmentionné. Chaque point-mémoire est formé d'un transistor T.

Chaque transistor comprend deux régions 1 constituées par une diffusion de type N+ dans un substrat 2 de type P. Chaque région 1 se prolonge suivant la direction des colonnes pour former une ligne de bit LB1, LB2, LB3.

Ces lignes de bit font office, à l'emplacement des transistors, soit de source, soit de drain.

Les grilles flottantes 3 des transistors sont réalisées par un premier niveau de silicium polycristallin (poly 1) et sont situées entre chaque paire de lignes de bit.

Une zone d'isolement 4 est située entre chaque paire de grilles flottantes de transistors. Une ligne de mot LM conductrice, réalisée par un deuxième niveau de silicium polycristallin (poly 2), recouvre, dans la direction des rangées, les grilles flottantes 3 et les zones d'isolement 4. Les grilles de commande 5 des transistors sont formées par des parties de la ligne de mot LM situées au-dessus de la grille flottante de chaque transistor.

Le mode de programmation de cette architecture est particulier. Il est exposé dans la demande de brevet français précitée. Cela est dû au fait que chaque point-mémoire partage avec chacun des deux points-mémoire adjacents de la même rangée une région qui peut être soit région de source, soit région de drain.

La présente invention propose une nouvelle structure en damier à très grande densité, et qui présente en outre un facteur de couplage nettement supérieur à celui obtenu avec la structure classique susmentionnée.

Ainsi, la présente invention prévoit une mémoire dont les points-mémoire sont constitués de transistors à grille flottante disposés matriciellement en rangées et colonnes, chaque transistor comprenant deux régions constituées de diffusions du premier type de conductivité qui se prolongent suivant des colonnes pour former des lignes de bit dans un substrat semiconducteur du deuxième type de conductivité, ces lignes de bit étant séparées à l'emplacement de chaque transistor par une région de grille, une couche d'isolement recouvrant chaque ligne de bit, des lignes de mot conductrices s'étendant selon des rangées pour recouvrir chacune des grilles flottantes des transistors de cette rangée. La grille flottante de chaque transistor est constituée d'une portion d'une unique couche conductrice qui s'étend entre chaque paire couches d'isolement et les recouvre partiellement, cette portion étant revêtue d'un isolant sur toutes ses surfaces.

La présente invention prévoit également un procédé de fabrication d'une telle mémoire.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1, déjà décrite, représente une vue partielle en coupe et en perspective de points-mémoire élémentaires d'une structure en damier ;

les figures 2A à 2E représentent les différentes étapes d'un procédé de fabrication selon l'invention ;

la figure 3 représente une vue de dessus de l'implantation de points-mémoire adjacents selon la présente invention ,

la figure 4 représente un schéma des capacités existant à l'emplacement d'un point-mémoire de la structure de la figure 2E ; et

les figures 5A à 5C représentent des étapes de fabrication d'un procédé selon une variante de l'invention.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

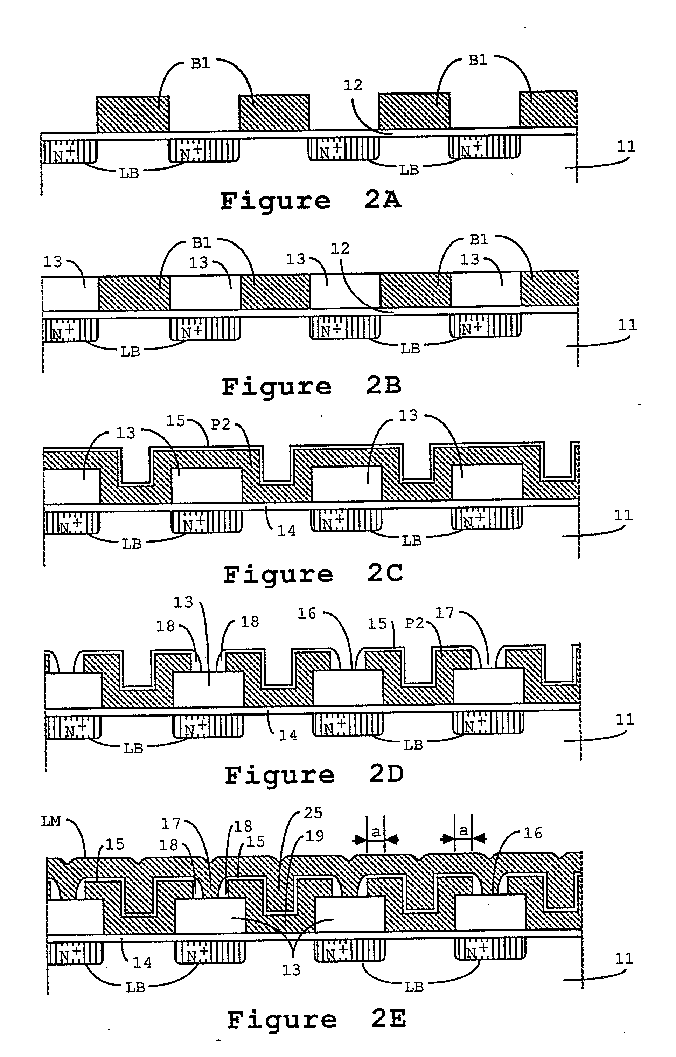

Les figures 2A à 2E représentent en coupe différentes étapes du procédé de fabrication d'une structure selon l'invention réalisée dans un substrat de silicium 11.

La figure 2A représente la structure à une étape préliminaire après réalisation d'une couche d'oxyde 12, et dépôt et gravure d'un premier niveau de silicium polycristallin (poly 1) pour former selon des colonnes des bandes B1 identiques et équidistantes.

La figure 2A représente également la structure après formation de régions de type N + qui constituent les lignes de bit LB. Ces régions sont réalisées par implantation en utilisant le premier niveau de silicium polycristallin comme masque.

La figure 2B représente la structure à une étape intermédiaire après dépôt d'une couche d'isolement 13 entre les différentes bandes de poly 1 B1. De façon classique, un procédé de planarisation est utilisé pour que les surfaces supérieures de cette couche d'isolement 13 et du premier niveau de silicium polycristallin soient au même niveau. Cette couche d'isolement 13 est constituée par exemple d'oxyde de silicium obtenu par dépôt en phase vapeur à partir d'une source TEOS (tétraéthyle ortho silicate).

La figure 2C représente la structure après élimination des bandes de poly 1 B1, élimination de la couche d'oxyde 12 à l'emplacement des bandes B1 et réalisation d'une couche d'oxyde de grille 14 à l'emplacement des bandes B1.

La figure 2C représente également la structure après dépôt uniforme d'un deuxième niveau P2 de silicium polycristallin (poly 2) et réalisation d'une couche d'isolant 15, que l'on appelle couramment couche d'oxyde interpoly, et qui est constituée par exemple d'un empilement de trois couches : Oxyde de silicium/Nitrure de silicium/Oxyde de silicium, désigné par ONO.

La figure 2D représente la structure à une étape intermédiaire après gravure de la couche d'oxyde interpoly 15 et du niveau P2 de poly 2 pour former au niveau de la surface supérieure 16 de chaque couche d'isolement 13 un espace 17.

La figure 2D représente également la structure après réalisation d'une zone d'oxyde 18, appelée zone d'oxyde de coin, sur les régions latérales apparentes du niveau P2 de poly 2.

La figure 2E représente la structure après dépôt d'un troisième niveau de silicium polycristallin (poly 3) à partir duquel sont formées les lignes de mot. On grave ensuite la couche de poly 3, la couche d'oxyde interpoly ONO 15 et la couche de poly 2 pour définir selon des rangées la ligne de mot LM formée dans le poly 3 et les grilles flottantes 19 formées dans le niveau P2 de poly 2, comme le montre la vue en perspective de la figure 1.

De façon classique, les étapes finales (non représentées) consistent à former une couche isolante d'encapsulation, à établir des contacts avec les lignes de mot et les lignes de bit, et à réaliser des métallisations.

La couche d'oxyde interpoly 15 et les zones d'oxyde de coin 18 servent à isoler les grilles flottantes des lignes de mot. Les lignes de mot font office de grilles de commande 25 à l'emplacement des grilles flottantes des transistors.

La grille flottante 19 de chaque transistor déborde d'une longueur a sur chacune des couches d'isolement qui l'entourent. Cette longueur a est la longueur minimale de tolérance de la technologie utilisée. Elle permet d'assurer que la grille flottante débordera toujours au-dessus des couches d'isolement 13.

La figure 3 représente une vue de dessus de l'implantation de quatre transistors de la structure à l'étape de fabrication de la figure 2E (toutefois les lignes de mot n'ont pas été représentées pour mieux montrer les grilles flottantes).

On retrouve sur cette figure 3 les couches d'isolement 13 qui recouvrent les lignes de bit. La grille flottante 19 de chaque transistor T est située entre deux couches d'isolement adjacentes et déborde sur chacune des couches d'isolement qui l'entourent de la longueur a.

Les lignes de mot LM (non représentées) recouvrent les grilles flottantes 19 et les zones d'isolement 13 entre les grilles flottantes.

La figure 4 représente un schéma des capacités existant à l'emplacement d'un transistor T. Si l'on applique une tension $v_M$ à la ligne de mot LM, on obtient la tension $V_F$ sur la grille flottante 19. Le facteur de couplage $\gamma$ qui relie ces deux tensions est donné par la relation :

$$V_F = \gamma V_M$$

Si l'on considère la figure 4, on observe la capacité au niveau de la couche d'oxyde interpoly 15 notée $C_{OI}$ et située entre la ligne de mot LM et la grille flottante 19. On a aussi une capacité $C_{OG}$ au niveau de la couche d'oxyde de grille 14 située entre la grille flottante 19 et le substrat 11. Il existe également, puisque la grille flottante déborde au dessus de chacune des zones d'isolement 13 qui l'entourent, une capacité $C_{OE1}$ et une capacité $C_{OE2}$ au niveau de la zone d'isolement, chacune de ces deux capacités correspondant au débordement selon un côté. Le facteur de couplage s'écrit donc :

$$\gamma = C_{OI}/(C_{OI} + C_{OE1} + C_{OG} + C_{OE2})$$

Le silicium polycristallin utilisé pour former la grille flottante 19 est déposé de façon à présenter une épaisseur semblable sur une surface de support horizontale ou verticale.

On considérera une structure dans laquelle l'espacement entre les couches d'isolement 13 est égal à la largeur de ces couches d'isolement et est désigné par L. Si l'on dépose le niveau de silicium P2 avec une épaisseur sur les couches d'isolement 13 égale à L/4, l'épaisseur des portions verticales de la grille flottante par rapport aux surfaces verticales des couches d'isolement sera aussi égale à L/4 et l'epaisseur de la portion de grille flottante située entre les portions verticales sera également L/4. Ainsi, la hauteur correspondant à la différence de niveau entre les différentes surfaces horizontales de la grille flottante sera égale à L/2. La longueur correspondant à l'espacement entre les deux portions verticales d'une même grille flottante sera aussi égale à L/2. Si l'on considère une longueur de débordement a de la grille flottante sur les zones d'isolement égale à L/4, ce qui correspond à un ordre de grandeur réaliste, chacune des deux surfaces horizontales supérieures de la grille flottante aura une longueur suivant la direction des rangées égale à L/2.

Ainsi, si l'on appelle w la dimension suivant des colonnes des grilles flottantes ou encore des lignes de mot, la valeur de la surface de la couche d'oxyde interpoly ONO située entre chaque grille flottante et la ligne de mot qui la recouvre sera égale à $2,5 \times L \times w$.

Les zones d'oxyde de coin 18 sont constituées par de l'oxyde de silicium formé à partir du silicium polycristallin de la grille flottante. Puisque l'oxyde de silicium ainsi formé présente des qualités d'isolement inférieures à celles de la couche ONO, les zones d'oxyde de coin sont réalisées avec une épaisseur supérieure à celle de la couche ONO afin d'obtenir une qualité sensiblement égale à celle de cette couche ONO. A cause de leur épaisseur plus grande, elles interviendront de façon beaucoup moins importante dans le calcul du couplage en comparaison avec la couche d'oxyde interpoly ONO. Les zones d'oxyde de coin 18 seront donc négligées pour ce calcul.

La surface de la couche d'oxyde de grille qui sépare chaque grille flottante 19 du substrat 11 est égale à $L \times w$.

L'épaisseur des zones d'isolement 13 est très supérieure à celle de la couche d'oxyde interpoly et à celle de la couche d'oxyde de grille. A titre d'exemple, pour une technologie permettant la fabrication de motifs de 1 micromètre, l'épaisseur des zones d'isolement est de l'ordre de 500 nanomètres alors que celle des couches d'oxyde interpoly et d'oxyde de grille est de l'ordre de 20 nm. Ainsi, les parties de zones d'isolement situées sous les débordements des grilles flottantes pourront être négligées lors du calcul du couplage. Dans la formule ci-dessus qui définit le facteur de couplage $\gamma$, on pourra négliger les quantités $C_{OE1}$ et $C_{OE2}$.

Si l'on appelle e1 et e2 les épaisseurs de la couche d'oxyde de grille et de la couche d'oxyde interpoly ONO respectivement, le facteur de couplage est égal au rapport entre les quantités $2,5 \times$

$L \times w/e2$ et $2,5 \times L \times w/e2 + L \times w/e1$.

Ainsi, si l'on considère une couche d'oxyde de grille et une couche d'oxyde interpoly ONO de même épaisseur, le facteur de couplage est :
$$\gamma = 2,5/3,5$$
$$\gamma = 0,71$$

On obtient un facteur de couplage indépendant de la technologie de fabrication. La seule hypothèse faite dans ce calcul a été de considérer des épaisseurs égales de couche d'oxyde de grille et de couche d'oxyde interpoly.

Dans le cas d'une structure de type damier classique, le facteur de couplage $\gamma 1$ s'écrit, en supposant les épaisseurs de couche d'oxyde de grille et de couche d'oxyde interpoly égales et en désignant par L1 la dimension, suivant la direction des rangées, des grilles flottantes et par w1 la dimension, suivant la direction des colonnes, des grilles flottantes ou des lignes de mot :
$$\gamma 1 = (L1 \times w1)/(L1 \times w1 + L1 \times w1)$$
$$\gamma 1 = 0,5$$

La structure selon l'invention permet ainsi d'améliorer nettement le facteur de couplage indépendamment des dimensions de la technologie et en augmentant les dimensions d'un point-mémoire élémentaire seulement d'une longueur suivant la direction des rangées égale à deux fois la longueur minimale de tolérance (a) de la technologie.

On considèrera de nouveau dans la structure de la figure 2E le cas où l'épaisseur de la partie de la grille flottante qui déborde au-dessus des zones d'isolement est égale à L/4, l'épaisseur de la partie verticale de la grille flottante est égale aussi à L/4 et l'épaisseur de la partie de la grille flottante qui se trouve entre les deux parties verticales est encore égale à L/4. Le fait de déposer le niveau de poly 3, pour former la ligne de mot LM, avec une épaisseur égale à L/4 sur les surfaces horizontales supérieures des grilles flottantes permet de combler directement les espaces entre les deux parties verticales d'une même grille flottante ainsi que les espaces entre les zones d'oxyde de coin 18. Cela est dû au fait que les épaisseurs des parties de silicium polycristallin déposées sur une surface horizontale ou bien sur une surface verticale sont égales.

On obtient ainsi directement une surface supérieure de ligne de mot régulière, ce qui est très intéressant dans le cas de l'utilisation de ligne de mot avec siliciure (pour éviter les fissures qui apparaissent sur les zones à topologie tourmentée).

Il peut être intéressant de modifier les dimensions de certains éléments du circuit. On peut par exemple vouloir augmenter l'épaisseur des lignes de mot afin d'en diminuer la résistance. Dans le cas d'une technologie à grande dimension, la grille flottante des transistors peut être réduite et conserver encore de bonnes propriétés.

Avec les dimensions suivantes :
- dimension suivant la direction des rangées de la grille flottante des transistors et des couches d'isolement : L,
- épaisseur de la partie de grille flottante qui déborde au-dessus des couches d'isolement : L/6,
- épaisseur de chaque partie verticale des grilles flottantes : L/6,
- épaisseur de la partie de grille flottante située entre les parties verticales de ces grilles flottantes : L/6,
- épaisseur de poly 3 au-dessus des surfaces horizontales supérieures des grilles flottantes : L/3, les espaces entre deux parties verticales d'une même grille flottante ainsi que les espaces entre deux zones d'oxyde de coin seront directement comblés lors du dépôt du niveau de poly 3.

Ainsi, on pourra ajuster les épaisseurs des grilles flottantes des transistors et les épaisseurs des lignes de mot en fonction de certains critères tels que règles de dessin, résistance des lignes de mot, tout en obtenant directement une surface régulière de ces lignes de mot, par le choix de paramètres adaptés (par exemple le couple (L/3, L/6).

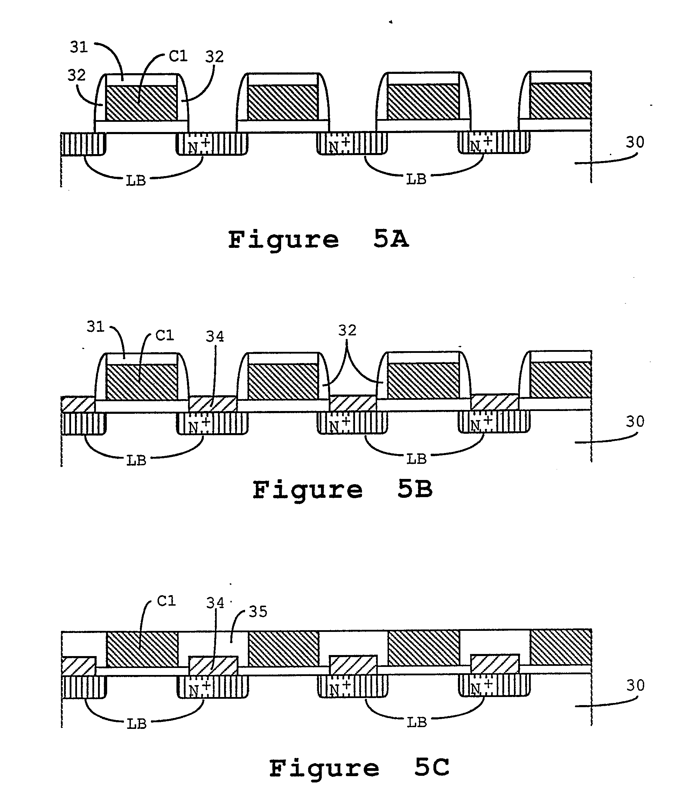

Les figures 5A, 5B et 5C représentent des étapes de fabrication d'une structure selon une variante de l'invention réalisée dans un substrat de silicium 30.

La figure 5A représente cette structure à une étape préliminaire après dépôt d'un premier niveau de silicium polycristallin et réalisation d'une couche d'isolant 31, gravure de cette couche d'isolant 31 et du niveau de poly 1 pour former des bandes C1 de poly 1 identiques et équidistantes.

La figure 5A représente la structure après formation d'une couche d'isolant 32 également appelée couche d'oxyde de flanc sur les surfaces verticales des bandes de poly 1 C1 et mise à nu des régions de substrat situées entre deux bandes de poly 1 C1 adjacentes.

Des régions de type N$^+$ qui constituent les lignes de bit LB de la mémoire sont formées dans le substrat.

La figure 5B représente la structure à une étape intermédiaire après dépôt uniforme d'un métal réfractaire (par exemple le tungstène ou le tantale), formation d'un siliciure de ce métal réfractaire et de silicium et élimination par attaque sélective du métal résiduel. Il ne reste ainsi que des zones 34 constituées de siliciure autoaligné sur les zones N+ LB.

La figure 5C représente la structure après dépôt d'une couche d'isolement 35 entre les couches d'oxyde de flanc des différentes bandes C1. De façon classique, un procédé de planarisation est utilisé pour que les surfaces supérieures de cette couche disolement 35 et du premier niveau de silicium polycristallin soient au même niveau.

Les étapes suivantes du procédé de fabrication de cette structure selon une variante de l'invention sont identiques aux étapes décrites avec les figures 2C à 2E.

Cette variante permet, par la présence des zones de silicium 34 directement en contact avec les lignes de bit LB, de diminuer la résistance de ces lignes de bit et ainsi d'améliorer les performances du circuit.

Dans les structures présentées sur les figures 2 à 5, la programmation d'un point-mémoire doit tenir compte des points-mémoire adjacents. Cela rend le système d'adressage complexe. Si l'on connecte par le système d'adressage deux transistors adjacents d'une même rangée pour former un point-mémoire unique, il sera possible d'utiliser une section d'adressage classique. La mémoire aura alors une structure dite en demi-damier.

La présente invention est susceptible de diverses variantes et modifications. Par exemple, les types de conductivité N et P pourraient être échangés et les enseignements de l'invention peuvent être combinés à l'état connu de la technique des mémoires à semiconducteur.

## Revendications

1. Mémoire dont les points-mémoire sont constitués de transistors à grille flottante disposés matriciellement en rangées et colonnes, chaque transistor comprenant deux régions constituées de diffusions de drain et de source d'un premier type de conductivité qui se prolongent suivant des colonnes pour former des lignes de bit (LB) dans un substrat semiconducteur (11) du deuxième type de conductivité caractérisée en ce que la surface du semiconducteur est plane après formation des régions de drain et de source, une couche d'isolement (13) recouvrant chaque ligne de bit, la grille flottante (19) de chaque transistor étant constituée d'une portion d'une unique couche conductrice qui s'étend entre chaque paire de couches d'isolement et les recouvre partiellement, des lignes de mot (LM) conductrices s'étendant selon des rangées pour recouvrir chacune des grilles flottantes des transistors de cette rangée en étant séparées des grilles flottantes par un isolant.

2. Mémoire selon la revendication 1, caractérisée en ce que la couche conductrice constituant les grilles flottantes est une couche de silicium polycristallin.

3. Mémoire selon l'une des revendications 1 ou 2, caractérisée en ce que la grille flottante (19) déborde sur chacune des deux couches d'isolement (13) qui l'entourent d'une longueur (a) correspondant à la longueur minimale de tolérance de la technologie.

4. Mémoire selon l'une quelconque des revendications 1 à 3, caractérisée en ce que les lignes de mot (LM) sont réalisées par un niveau de silicium polycristallin.

5. Mémoire selon l'une quelconque des revendications 1 à 4, caractérisée en ce qu'une zone de siliciure (34) s'étend selon la direction des colonnes sur les lignes de bit, est en contact direct avec les lignes de bit et est recouverte d'isolant sur ses surfaces supérieures et latérales.

6. Procédé de fabrication de mémoire de type MOS à transistors à grille flottante disposés selon des rangées et des colonnes sur un substrat (11) d'un premier type de conductivité, comprenant les étapes suivantes :

a) déposer et graver un premier niveau de silicium polycristallin pour former selon des colonnes des bandes identiques et équidistantes (B1),

b) réaliser une implantation du deuxième type de conductivité en utilisant le premier niveau de silicium polycristallin comme masque,

c) remplir de couches d'isolement (13) l'intervalle entre les bandes (B1) de premier niveau de silicium polycristallin,
caractérisé en ce qu'il comprend en outre les étapes suivantes :

d) éliminer les bandes (B1) de premier niveau de silicium polycristallin,

e) déposer uniformément un deuxième niveau de silicium polycristallin,

f) isoler superficiellement (15) le deuxième niveau de silicium polycristallin,

g) graver le deuxième niveau de silicium polycristallin pour former au niveau de la surface supérieure (16) de chaque couche d'isolement (13) un espace (17) dans le deuxième niveau de silicium polycristallin,

h) isoler latéralement (18) les régions apparentes du deuxième niveau de silicium polycristallin,

i) déposer un troisième niveau de silicium polycristallin (LM),

j) graver par un même masque, selon des rangées, les deuxième et troisième niveaux de silicium polycristallin,

k) former une couche isolante, et

l) établir des contacts avec les bandes restantes du troisième niveau de silicium polycristallin (lignes de mot) et les colonnes de source ou drain (lignes de bit).

7. Procédé de fabrication de mémoire selon la revendication 6, caractérisé en ce que l'isolement superficiel (15) du deuxième niveau de silicium polycristallin (étape f) est constitué par un empilement de trois couches : oxyde de silicium/nitrure de silicium/oxyde de silicium.

8. Procédé de fabrication de mémoire selon la revendication 6, caractérisé en ce que les couches d'isolement (13) entre les bandes (B1) de premier niveau de silicium polycristallin sont constituées d'oxyde de silicium obtenu par dépôt en phase vapeur à partir d'une source TEOS (tétraéthyle ortho silicate).

9. Procédé de fabrication de mémoire selon la revendication 6, caractérisé en ce qu'il comprend entre les étapes b et c les étapes consistant à former une couche de siliciure d'un métal réfractaire à la surface des régions ayant subi une implantation du deuxième type de conductivité.

Figure 1

B1     B1    12    B1

N⁺   N⁺   N⁺   N⁺

LB      LB     11

## Figure  2A

13   B1   13   13   12   B1   13

N⁺   N⁺   N⁺   N⁺   11

LB      LB

## Figure  2B

13   15   P2   13

N⁺   N⁺   N⁺   N⁺

14   11

LB      LB

## Figure  2C

13   16   17
18   18   15   P2

N⁺   N⁺   N⁺   N⁺

14   11

LB      LB

## Figure  2D

LM   17   18   25    a    a    16
15   18   15   19

N⁺   N⁺   N⁺   N⁺

14   13   11

LB      LB

## Figure  2E

Figure 3

Figure 4

**Figure   5A**

**Figure   5B**

**Figure   5C**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 763 177 (PATERSON)<br>* Colonne 3, ligne 23 - colonne 7, ligne 30; figures 1-19 *<br>--- | 1,2,4-7 ,9 | H 01 L 29/788<br>H 01 L 27/10<br>H 01 L 21/82<br>G 11 C 17/00 |
| A | US-A-4 698 900 (ESQUIVEL)<br>* Figure 1 *<br>--- | 1,2,4 | |
| A | US-A-4 377 818 (KUO et al.)<br>* Colonne 3, ligne 11 - colonne 6, ligne 3; figures 4A-4E *<br>----- | 1,6,7 | |

**DOMAINES TECHNIQUES RECHERCHES (Int. Cl.5)**

H 01 L

Le présent rapport a été établi pour toutes les revendications

| Lieu de la recherche | Date d'achèvement de la recherche | Examinateur |
|---|---|---|
| LA HAYE | 23-01-1990 | BAILLET B.J.R. |

EPO FORM 1503 03.82 (P0402)